# EUROPEAN PATENT APPLICATION

(11) **EP 2 826 818 A1**
(43) Date of publication of application: **21.01.2015**
(21) Application number: 13761194.3
(22) Date of filing: 08.03.2013
(51) Int. Cl.: C08L 77/00, C08G 69/02, H01L 21/56, H01L 23/29, H01L 23/31, H05K 3/28

(54) **SEALANT PASTE AND SEALING METHOD**

(30) Priority: 16.03.2012 JP 2012059970
(71) Applicant: Daicel-Evonik Ltd., Shinjuku-ku, Tokyo 163-0912 (JP)
(72) Inventor: ARITA Hiroaki, Himeji-shi Hyogo 671-1281 (JP); NAKAIE Yoshiki, Himeji-shi Hyogo 671-1281 (JP); MUTSUDA Mitsuteru, Himeji-shi Hyogo 671-1281 (JP)
(74) Representative: Grünecker, Kinkeldey, Stockmair & Schwanhäusser
(86) International application number: PCT/JP2013/056424
(87) International publication number: WO 2013/137130

(57) **Abstract**

A paste sealant capable of shortening sealing and molding cycles in spite of containing an aqueous medium and a sealing method of using the sealant are provided.

The paste sealant for molding and sealing a device comprises a copolyamide-seriesresin and an aqueous medium. The copolyamide-series resin may be a crystalline resin. The copolyamide-series resin may have a melting point or softening point of 75 to 160°C. The copolyamide-series resin may be a multiple copolymer, e.g., a binary or ternary copolymer. Further, the copolyamide-series resin may contain a unit derived from a long-chain component having a C₈₋₁₆alkylene group (at least one component selected from the group consisting of a C₉₋₁₇lactam and an aminoC₉₋₁₇alkanecarboxylic acid). The paste sealant may further contain a thickener [e.g., a (meth)acrylic polymer].

## Description

### TECHNICAL FIELD

The present invention relates to a paste sealant suitable for sealing a device (or an electronic device) such as a printed wiring board mounted with an electronic part, and a sealing method using the paste sealant.

### BACKGROUND ART

In order to protect a precision part (or an electronic device) against moisture, dust and other unfavorable substances, the precision part (such as a semiconductor element, a printed wiring board, or a solar cell) is sealed (or encapsulated) with a resin. As the sealing method, a known method of sealing a precision part comprises placing the precision part in a mold cavity and injecting a resin into the cavity. This method uses a thermosetting resin having a low viscosity and a high flowability in many cases.

However, the thermosetting resin shortens a storage life due to an additive (such as a crosslinking agent) added to the thermosetting resin, and requires a relatively long time from injection of the resin into a mold cavity to curing of the resin. Thus, the thermosetting resin cannot allow improvement of efficient production. Further, depending on the species of the resin, it is necessary to cure the resin after molding, which lowers production efficacy.

Moreover, it is known that a thermoplastic resin is injection-molded to seal a precision part. The thermoplastic resin, however, is practically injected at a relatively high temperature and high pressure, and thus a substrate or an electronic part mounted on a substrate is liable to damage and loses the reliability. Japanese Patent Application Laid-Open Publication No. 2000-133665 (JP-2000-133665A, Patent Document 1) discloses a method of sealing a printed wiring board mounted with an electronic part, the method comprising placing a printed wiring board equipped with an electronic part in a mold cavity and injecting a heat-melted polyamide resin having a temperature of 160 to 230°C into the mold cavity at a pressure range of 2.5 to 25 kg/cm². This document discloses in Examples that a polyamide resin (Series Number 817) manufactured by TRL (France) is injected into a mold at a melting temperature of 190°C and a pressure of 20 kg/cm² to seal a printed wiring board. This method, however, also exposes the electronic part to relatively high temperature and high pressure, and the electronic part is sometimes damaged.

Further, it is also known to seal a device using a film sealant. Japanese Patent Application Laid-Open Publication No. 2008-282906 (JP-2008-282906A, Patent Document 2) relates to a process for producing a solar cell module comprising a solar cell sealed between a substrate and a film by a resin; in the process, a first sealing-resin sheet substantially covering the whole surface of the substrate is disposed between the substrate and the solar cell, and a second sealing-resin sheet substantially covering the whole surface of the substrate is disposed between the film and the solar cell for preparing a layered structure. Apluralityof the layered structures are stacked while a back plate is disposed outside the film of an uppermost layered structure, air between the substrate and the film is discharged and the resin is heat-melted and then cooled to seal the cell. This document discloses that the sealing-resin is selected from the group consisting of an ethylene-vinyl acetate copolymer, a poly(vinyl butyral), and a polyurethane.

Japanese Patent Application Laid-Open Publication No. 2009-99417 (JP-2009-99417A, Patent Document 3) discloses an organic electronic device sealing panel which comprises a substrate, an organic electronic device formed on the substrate, and a barrier film sealing the organic electronic device, and a hot-melt member is disposed between the organic electronic device and the barrier film. This document also discloses that the hot-melt member contains a moisture scavenger and a wax and that the hot-melt member is in a thin film having a thickness of not more than 100 µm. Moreover, Japanese Patent Application Laid-Open Publication No. 2009-99805 (JP-2009-99805A, Patent Document 4) discloses a hot-melt member for an organic thin-film solar cell, the member containing a moisture scavenger and a wax. These documents also disclose that the hot-melt member may be in the form of a thin-film, a plate, an amorphous or indefinite, and others.

The film sealant, however, has low adaptability to an uneven portion (a depressed or raised portion) of a device, and thus it is difficult to seal the detailed exact or minute form of the device tightly. Further, since the above hot -melt member comprises a wax as a main component, it is difficult to seal the device with higher adhesion.

Japanese Patent Application Laid-Open Publication No. 2001-234125 (JP-2001-234125A, Patent Document 5) discloses a powder coating material for thermal spray coating; in order to prevent the coating material from discoloring even when exposed to high-temperature flames in a coating process, the coating material comprises 0.05 to 2.0 parts by weight of a hindered phenolic antioxidant and 0.05 to 2.0 parts by weight of a phosphite-series antioxidant relative to 100 parts by weight of a thermoplastic resin, and has a medium particle diameter of 50 to 300 µm, a bulk specific gravity of not less than 0.30 g/ml and an angle of repose of not more than 35°. In this document, the thermoplastic resin includes a polyethylene resin,a polypropylene resin, anylon- 11 resin, anylon-12 resin, an ethylene -vinyl acetate copolymer resin, an ethylene-acrylic acid copolymer resin, an ethylene-methacrylic acid copolymer resin, a modified polyethylene resin, and a modified polypropylene resin. An example using a nylon (polyamide) resin (trade name "Grilamid" manufactured by EMS-CHEMIE AG) is also described in this document.

Since the above-mentionedpowder coatingmaterial, however, is melted and sprayed at a high temperature, there is a possibility to easily damage the electronic part in the sealing process and the reliability of the device.

### RELATED ART DOCUMENTS

### PATENT DOCUMENTS

Patent Document 1: JP-2000-133665A (Claims and Examples)
Patent Document 2: JP-2008-282906A (Claims)
Patent Document 3: JP-2009-99417A (Claims and [0024])
Patent Document 4: JP-2009-99805A (Claims)
Patent Document 5: JP-2001-234125A (Claims, [0008], and Example 6)

### SUMMARY OF THE INVENTION

### PROBLEMS TO BE SOLVED BY THE INVENTION

It is therefore an object of the present invention to provide a paste sealant which allows shortening of sealing and molding cycles even in a case where the paste sealant contains an aqueous medium, and a sealing method using the paste sealant.

Another object of the present invention is to provide a paste sealant which can uniformly and securely seal a predetermined site of a device, and a sealing method using the paste sealant.

It is still another object of the present invention to provide a paste sealant which tightly seals a device even having an uneven portion, and a sealing method using the paste sealant.

It is another object of the present invention to provide a paste sealant which can effectively protect a device against moisture, dust or impact, and a sealing method using the paste sealant.

It is a still further object of the present invention to provide a device sealed with the sealant.

### MEANS TO SOLVE THE PROBLEMS

The inventors of the present invention made intensive studies to achieve the above objects and finally found that, in spite of containing an aqueous medium, a paste sealant containing a powdery copolyamide-series resin allows shortening of sealing and molding cycles and molding of a device or a substrate with high adhesion and seal-ability without restriction by the size of the device or the substrate , wherein the sealant molds a predetermined site of the device or the substrate uniformly and securely and follows an uneven surface of the device or the substrate easily. The present invention was accomplished based on the above findings.

That is, the paste sealant of the present invention is a paste sealant for molding and sealing (or encapsulating) a device and comprises a copolyamide-series resin and an aqueous medium. The paste sealant may further contain a thickener [for example, a (meth)acrylic acid-series polymer (a homo- or co-polymer of (meth) acrylic acid or a salt thereof)]. At a temperature of 23°C, the paste sealant may have a viscosity of about 1.5 to 25 Pa·s measured at a rotational frequency (or the number of rotations) of 62.5 rpm by B-type viscometer. At a temperature of 23°C, the ratio (V1/V2 or thixotropic index) of the viscosity (V1) of the paste sealant measured at a rotational frequency of 2 rpm by B-type viscometer relative to the viscosity (V2) of the paste sealant measured at a rotational frequency of 20 rpm by B-type viscometer may be about 1. 5 to 8. The ratio of the copolyamide-series resin relative to 100 parts by weight of the aqueous medium may be about 10 to 100 parts by weight.

The copolyamide-series resin may have a melting point or softening point of about 75 to 160°C, for example, a melting point or softening point of about 90 to 160°C. The copolyamide-series resin may be crystalline. The copolyamide-series resinmay comprise a multiple copolymer, for example, at least one selected from the group consisting of a binary copolymer to a quaternary copolymer (e.g., a binary copolymer or a ternary copolymer) . Further, the copolyamide-series resin may contain a unit derived from a long-chain component having a C₈₋₁₆alkylene group (such as a C₁₀₋₁₄alkylene group), for example, at least one component selected from the group consisting of a C₉₋₁₇lactam and an aminoC₉₋₁₇alkanecarboxylic acid. For example, the copolyamide-series resin may contain a unit derived from an amide-forming (or amide-formable) component (or an amide-forming component for forming a polyamide) selected from the group consisting of a polyamide 11, a polyamide 12, a polyamide 610, a polyamide 612, and a polyamide 1010; the copolyamide-series resin may comprise at least one member selected from the group consisting of a copolyamide 6/11, a copolyamide 6/12, a copolyamide 66/11, a copolyamide 66/12, a copolyamide 610/11, a copolyamide 612/11, a copolyamide 610/12, a copolyamide 612/12, a copolyamide 1010/12, a copolyamide 6/11/610, a copolyamide 6/11/612, a copolyamide 6/12/610, and a copolyamide 6/12/612. Moreover, the copolyamide-series resin may be a polyamide elastomer (a polyamide block copolymer) containing a unit (polyamide unit or block) derived from an amide-forming component (or an amide-forming component for forming a polyamide) selected from the group consisting of a polyamide 11, a polyamide 12, a polyamide 610, a polyamide 612 and a polyamide 1010 as a hard segment, if necessary. Further, the copolyamide-series resin may contain a unit derived from at least one component selected from the group consisting of laurolactam, aminoundecanoic acid, and aminododecanoic acid.

A process according to the present invention can produce a device covered or molded with a copolyamide-series resin by applying the paste sealant on at least a region (or a portion) of the device, heat-melting the paste sealant, and cooling the paste sealant. Thus, the present invention also includes a device (a covered or molded device) of which at least a region (or a portion) is covered or molded with a copolyamide-series resin layer comprising the paste sealant.

Throughout this description, the term "copolyamide-series resin" means not only a copolymer (a copolyamide) of a plurality of amide-forming components, each forming a homopolyamide, but also a mixture of a plurality of copolymers (copolyamides) with different in kind, each containing units of a plurality of the amide-forming components.

### EFFECTS OF THE INVENTION

According to the present invention, a paste sealant containing a powdery copolyamide-series resin allows shortening of sealing and molding cycles even in a case where the sealant contains an aqueous medium; and the paste sealant does not damage the reliability of the device. Moreover, according to the present invention, the sealant can tightly seal a device by uniformly and securely sealing a predetermined site of a device and easily follow an uneven surface of the device even in a case where the device has such an uneven surface. Thus, the sealant can effectively protect an electronic device against moisture, dust, impact, or others.

### DESCRIPTION OF EMBODIMENTS

The paste sealant (sealant in the form of a paste) of the present invention contains a copolyamide-series resin (a powdery copolyamide-series resin or a copolyamide-series resin particle) and an aqueous medium. The copolyamide-series resin may include a copolyamide (a thermoplastic copolyamide) and a polyamide elastomer.

The thermoplastic copolyamide may be an alicyclic copolyamide and usually an aliphatic copolyamide. The copolyamide may be formed by combination of a diamine component, a dicarboxylic acid component, a lactam component, and an aminocarboxylic acid component. The combination of the diamine component and the dicarboxylic acid component forms an amide bond of the copolyamide; each of the lactam component and the aminocarboxylic acid component can independently form an amide bond of the copolyamide. Thus, a pair of components (combination of a diamine component and a dicarboxylic acid component), a lactam component, and an aminocarboxylic acid component each may be referred to as an amide-forming component. From these viewpoints, the copolyamide can be obtained by copolymerization of a plurality of amide-forming components selected from the group consisting of a pair of components (combination of a diamine component and a dicarboxylic acid component), a lactam component, and an aminocarboxylic acid component. Moreover, the copolyamide can be obtained by copolymerization of at least one amide-forming component selected from the group consisting of apair of components (combination of a diamine component and a dicarboxylic acid component), a lactam component and an aminocarboxylic acid component, and another amide-forming component different in kind from the above amide-forming component (or being the same kind as the above amide-forming component but different in the carbon number from the above amide-forming component). Moreover, the lactam component and the aminocarboxylic acid component may be presumed as an equivalent component as far as these components have the same carbon number and chain structure such as a branched structure. Thus, assuming that the pair of components composed of the diamine component and the dicarboxylic acid component is a first amide-forming component and that at least one of the lactam component and the aminocarboxylic acid component is a second amide-forming component, the copolyamide may for example be the following: a copolyamide of the first amide-forming component (the diamine component and the dicarboxylic acid component), wherein at least one of the diamine component and the dicarboxylic acid component comprises a plurality of components with different carbon number; a copolyamide of the first amide-forming component (the diamine component and the dicarboxylic acid component) and the second amide-forming component (at least one component selected from the group consisting of the lactam component and the aminocarboxylic acid component); a copolyamide of the second amide-forming component (at least one component selected from the group consisting of the lactam component and the aminocarboxylic acid component), wherein one of the lactam component and the aminocarboxylic acid component comprises a plurality of components with different carbon number; and a copolyamide of the lactam component and the aminocarboxylic acid component, wherein these components are the same or different in the carbon number from each other.

The diamine component may include an aliphatic diamine or alkylenediamine component (for example, a C₄₋₁₆alkylenediamine such as tetramethylenediamine, hexamethylenediamine, trimethylhexamethylenediamine, octamethylenediamine, or dodecanediamine), and others. These diamine components may be used singly or in combination. The preferred diamine component contains at least an alkylenediamine (preferably a C₆₋₁₄alkylenediamine, more preferably a C₆₋₁₂alkylenediamine).

If necessary, the diamine component may further contain an alicyclic diamine component {for example, a diaminocycloalkane such as diaminocyclohexane (e.g., a diaminoC₅₋₁₀cycloalkane); a bis(aminocycloalkyl)alkane [e.g., a bis(aminoC₅₋₈cycloalkyl) C₁₋₃alkane] such as bis(4-aminocyclohexyl)methane, bis(4-amino-3-methylcyclohexyl)methane, or 2,2-bis(4'-aminocyclohexyl)propane; a hydrogenated xylylenediamine} or an aromatic diamine component (e.g., m-xylylenediamine). The above diamine component (for example, an alicyclic diamine component) may have a substituent such as an alkyl group (a C₁₋₄alkyl group such as methyl group or ethyl group).

The proportion of the alkylenediamine component in the total diamine component may be about 50 to 100% by mol, preferably about 60 to 100% by mol (e.g., about 70 to 97% by mol), and more preferably about 75 to 100% by mol (e.g., about 80 to 95% by mol).

The dicarboxylic acid component may include an aliphatic dicarboxylic acid or alkanedicarboxylic acid component [for example, a dicarboxylic acid having about 4 to 36 carbon atoms or a C₄₋₃₆alkanedicarboxylic acid (such as adipic acid, pimelic acid, azelaic acid, sebacic acid, dodecanedioic acid, dimer acid or a hydrogenated product thereof)]. These dicarboxylic acid components may be used singly or in combination. The preferred dicarboxylic acid component contains a C₆₋₃₆alkanedicarboxylic acid (for example, a C₆₋₁₆alkanedicarboxylic acid, preferably a C₈₋₁₄alkanedicarboxylic acid). If necessary, the dicarboxylic acid component may further contain an alicyclic dicarboxylic acid component (for example, a C₅₋₁₀cycloalkane-dicarboxylic acid such as cyclohexane-1,4-dicarboxylic acid or cyclohexane-1,3-dicarboxylic acid) or an aromatic dicarboxylic acid (such as terephthalic acid or isophthalic acid). An alicyclic polyamide resin obtained from the alicyclic diamine component and/or the alicyclic dicarboxylic acid component in combination with the aliphatic diamine component and/or the aliphatic dicarboxylic acid component, as the diamine component and the dicarboxylic acid component, is known as a transparent polyamide having a high transparency.

The proportion of the alkanedicarboxylic acid component in the total dicarboxylic acid component may be about 50 to 100% by mol, preferably about 60 to 100% by mol (e.g. , about 70 to 97% by mol), and more preferably about 75 to 100% by mol (e.g., about 80 to 95% by mol).

In the first amide-forming component, the diamine component can be used in the range of about 0.8 to 1.2 mol and preferably about 0.9 to 1.1 mol relative to 1 mol of the dicarboxylic acid component.

The lactam component may include, for example, a C₄₋₂₀lactam such as δ-valerolactam, ε-caprolactam, ω-heptalactam, ω-octalactam, ω-decanelactam, ω-undecanelactam, or ω-laurolactam (or ω-laurinlactam). The aminocarboxylic acid component may include, for example, a C₆₋₂₀aminocarboxylic acid such as ω-aminodecanoic acid, ω-aminoundecanoic acid, or ω-aminododecanoic acid. These lactam components and aminocarboxylic acid components may also be used singly or in combination.

The preferred lactam component contains a C₆₋₁₉lactam, preferably a C₈₋₁₇lactam, and more preferably a C₁₀₋₁₅lactam (e.g., laurolactam). Moreover, the preferred aminocarboxylic acid contains an aminoC₆₋₁₉alkanecarboxylic acid, preferably an aminoC₈₋₁₇alkanecarboxylic acid, and more preferably an aminoC₁₀₋₁₅alkanecarboxylic acid (such as aminoundecanoic acid or aminododecanoic acid).

The copolyamide may be a modified polyamide such as a polyamine having a branched chain structure formed by introduction of a small amount of a polycarboxylic acid component and/or a polyamine component.

The ratio (molar ratio) of the first amide-forming component (combination of both the diamine component and the dicarboxylic acid component) relative to the second amide-forming component (at least one amide-forming component selected from the group consisting of the lactam component and the aminocarboxylic acid component) can be selected from the range of 100/0 to 0/100 in a ratio of the former/the latter, and may for example be about 90/10 to 0/100 (e.g., about 80/20 to 5/95), preferably about 75/25 to 10/90 (e.g., about 70/30 to 15/85), and more preferably about 60/40 to 20/80 in a ratio of the former/the latter.

Further, the copolyamide preferably contains a long-chain component having a long fatty chain [a higher (or long-chain) alkylene group or alkenylene group] as a polymer unit (or contains a unit derived from the long-chain component). The long-chain component may include a component having a long fatty chain or alkylene group with about 8 to 36 carbon atoms (preferably a C₈₋₁₆alkylene group, and more preferably a C₁₀₋₁₄alkylene group). As the long-chain component, for example, there may be mentioned at least one component selected from the group consisting of a C₈₋₁₈alkanedicarboxylic acid (e.g., preferably a C₁₀₋₁₆alkanedicarboxylic acid, and more preferably a C₁₀₋₁₄alkanedicarboxylic acid), a C₉₋₁₇lactam (preferably a C₁₁₋₁₅lactam such as laurolactam), and an aminoC₉₋₁₇alkanecarboxylic acid (preferably an aminoC₁₁₋₁₅alkanecarboxylic acid such as aminoundecanoic acid or aminododecanoic acid). These long-chain components may be used singly or in combination. Among these long-chain components, a practically used component includes the lactam component and/or the aminoalkanecarboxylic acid component, for example, at least one component selected from the group consisting of laurolactam, aminoundecanoic acid, and aminododecanoic acid. The copolyamide containing a unit derived from the long-chain component has high water resistance as well as excellent adhesion to an electronic device, excellent abrasion resistance, and excellent impact resistance, and therefore protects an electronic device effectively.

The proportion of the long-chain component in the total monomer components for forming the copolyamide may be about 10 to 100% by mol (e.g. , about 25 to 95% by mol), preferably about 30 to 90% by mol (e.g., about 40 to 85% by mol), and more preferably about 50 to 80% by mol (e.g. , about 55 to 75% by mol).

Further, the copolyamide may be a multiple copolymer of the above amide-forming components, for example, anyone of a binary copolymer to a quinary copolymer. The copolyamide is usually any one of a binary copolymer to a quaternary copolymer, and particularly a binary copolymer or a ternary copolymer.

The copolyamide practically contains, for example, an amide-forming component (an amide-forming component for forming a polyamide) selected from the group consisting of a polyamide 11, a polyamide 12, a polyamide 610, a polyamide 612, and a polyamide 1010 as a constitutional unit (or contains a unit derived from the above amide-forming component). The copolyamide may be a copolymer of a plurality of the amide-forming components or may be a copolymer of one or a plurality of the amide-forming components and another amide-forming component (e.g. , at least one amide-forming component for forming a polyamide selected from the group consisting of a polyamide 6 and a polyamide 66). Specifically, the copolyamide includes, for example, a copolyamide 6/11, a copolyamide 6/12, a copolyamide 66/11, a copolyamide 66/12, a copolyamide 610/11, a copolyamide 612/11, a copolyamide 610/12, a copolyamide 612/12, a copolyamide 1010/12, a copolyamide 6/11/610, a copolyamide 6/11/612, a copolyamide 6/12/610, and a copolyamide 6/12/612. In these copolyamides, each component separated by the slash "/" indicates an amide-forming component.

As the polyamide elastomer (polyamide block copolymer), there may be mentioned a polyamide block copolymer composed of a polyamide as a hard segment (or a hard block) and a soft segment (or a soft block), for example, a polyamide-polyether block copolymer, a polyamide-polyester block copolymer, and a polyamide-polycarbonate block copolymer.

The polyamide constituting the hard segment may be a homo- or co-polymer (a homopolyamide or a copolyamide) formed by one or a plurality of the above amide-forming components. The homopolyamide as the hard segment may contain the above-exemplified long-chain component as a constitutional unit. The preferred long-chain component includes the same as one described above. A representative homopolyamide includes a polyamide 11, a polyamide 12, a polyamide 610, a polyamide 612, a polyamide 1010, a polyamide 1012, and others. Moreover, the copolyamide as the hard segment includes the same as the above-exemplified copolyamide. Among these polyamides, the preferred polyamide includes a homopolyamide (such as a polyamide 11, a polyamide 12 , a polyamide 1010, or a polyamide 1012).

A representative polyamide elastomer includes a polyamide-polyether block copolymer. In the polyamide-polyether block copolymer, the polyether (polyetherblock) mayinclude, for example, apoly(alkylene glycol) [e.g., a poly (C₂₋₆alkylene glycol), preferably a poly (C₂₋₄alkylene glycol), such as a poly (ethylene glycol), a poly(propylene glycol), or a poly(tetramethylene glycol)].

As examples of the polyamide-polyether block copolymer, there may be mentioned a block copolymer obtainable by copolycondensation of a polyamide block having a reactive terminal group and a polyether block having a reactive terminal group, for example, a polyetheramide [e.g., a block copolymer of a polyamide block having a diamine end and a poly(alkylene glycol) block (or a polyoxyalkylene block) having a dicarboxyl end, and a block copolymer of a polyamide block having a dicarboxyl end and a poly(alkylene glycol) block (or a polyoxyalkylene block) having a diamine end]; and a polyetheresteramide [e.g., ablockcopolymerofapolyamide block having a dicarboxyl end and a poly (alkylene glycol) block (or a polyoxyalkylene block) having a dihydroxy end] . The polyamide elastomer may have an ester bond. In order to improve the acid resistance, the polyamide elastomer may be free from an ester bond. Moreover, a commercially available polyamide elastomer usually has no or few amino group.

In the polyamide elastomer (the polyamide block copolymer), the number average molecular weight of the soft segment (e.g., a polyether block, a polyester block, and a polycarbonate block) may be selected from the range of, e.g. , about 100 to 10000, and may be preferably about 300 to 6000 (e.g., about 300 to 5000), more preferably about 500 to 4000 (e.g., about 500 to 3000), and particularly about 1000 to 2000.

Moreover, in the polyamide elastomer (the polyamide block copolymer), the ratio (weight ratio) of the polyamide block (polyamide segment) relative to the soft segment block may for example be about 75/25 to 10/90, preferably about 70/30 to 15/85, and more preferably about 60/40 to 20/80 (e.g., about 50/50 to 25/75) in a ratio of the former/the latter.

These copolyamide-series resins maybe used singly or in combination. In a case where the plurality kind of copolyamide-series resins is used in combination, each copolyamide-series resin may have compatibility with each other. Among these copolyamide-series resins, in view of the ability to seal an electronic device, the copolyamide (anon-polyamide elastomer or a polyamide random copolymer) is preferred. In particular, it is preferred that the copolyamide contain an amide-forming component derived from a polyamide 12 as a constitutional unit.

The amino group concentration of the copolyamide-series resin is not particularly limited to a specific one, and may for example be about 10 to 300 mmol/kg, preferably about 15 to 280 mmol/kg, and more preferably about 20 to 250 mmol/kg.

The carboxyl group concentration of the copolyamide-series resin is not particularly limited to a specific one, and may for example about 10 to 300 mmol/kg, preferably about 15 to 280 mmol/kg, and more preferably about 20 to 250 mmol/kg. A high carboxyl group concentration of a copolyamide-series resin achieves high heat stability, which is advantageous.

The number average molecular weight of the copolyamide-series resin can be selected from the range of, e.g., about 5000 to 200000; and may for example be about 6000 to 100000, preferably about 7000 to 70000 (e.g., about 7000 to 15000), and more preferably about 8000 to 40000 (e.g., about 8000 to 12000); and is usually about 8000 to 30000. The molecular weight of the copolyamide-series resin can be measured by gel permeation chromatography using HFIP (hexafluoroisopropanol) as a solvent in terms of poly(methyl methacrylate).

The amide bond content per molecule of the copolyamide-series resin can be selected from the range of, for example, not more than 100 units. In respect of the ability to seal a device, the amide bond content may be about 30 to 90 units, preferably about 40 to 80 units, and more preferably about 50 to 70 units (e.g., about 55 to 60 units). The amide bond content can be calculated, for example, by dividing a number average molecular weight by a molecular weight of a repeating unit (1 unit).

The copolyamide-series resin may be amorphous (or non-crystalline) or may be crystalline. The copolyamide-series resin may have a degree of crystallinity of, for example, not more than 20% and preferably not more than 10%. The degree of crystallinity can be measured by a conventional method, for example, a measuring method based on density or heat of fusion, an X-ray diffraction method, and an absorption of infrared rays.

The thermal melting property of the amorphous copolyamide-series resin can be determined based on a softening temperature measured by a differential scanning calorimeter. The melting point of the crystalline copolyamide-series resin can be measured by a differential scanning calorimeter (DSC).

The copolyamide-series resin (or the copolyamide or the polyamide elastomer) may have a melting point or softening point of, for example, about 75 to 160°C (e.g. , about 80 to 150°C), preferably about 90 to 140°C (e.g., about 95 to 135°C), and more preferably about 100 to 130°C; and is usually about 90 to 160°C (e.g. , about 100 to 150°C). Because the copolyamide-series resin has a low melting point or softening point, the melted or molten resin is useful to follow an external shape (or a surface) of a device [e.g., an uneven surface of a device (such as a corner region forming a stepped section)]. When the copolyamide-series resin contains components compatible with each other to show a single peak by DSC, the melting point of the copolyamide-series resin means a temperature at the single peak; when the copolyamide-series resin contains components incompatible with each other to show a plurality of peaks by DSC, the melting point of the copolyamide-series resin means the highest temperature out of a plurality of temperature values showing the peaks.

The copolyamide-series resin preferably has a high melting flowability in order to follow an external shape (or surface) of a device (such as an uneven surface of a device) and to allow the copolyamide-series resin to enter in a gap (or a space) or other areas. The copolyamide-series resin may have a melt flow rate (MFR) of about 1 to 350 g/10 minutes, preferably about 3 to 300 g/10 minutes, andmorepreferablyabout 5 to 250 g/10 minutes at a temperature of 160°C under a load of 2.16 kg.

To the copolyamide-series resin, a homopolyamide (for example, a homopolyamide of a component for forming the copolyamide) may be added as far as the characteristics (such as adhesion) of the copolyamide-series resin are not damaged. The ratio of the homopolyamide may be not more than 30 parts by weight (e.g., about 1 to 25 parts by weight), preferably about 2 to 20 parts by weight, and more preferably about 3 to 15 parts by weight relative to 100 parts by weight of the copolyamide-series resin.

Moreover, if necessary, the copolyamide-series resin may contain another resin, for example, a thermosetting resin (such as an epoxy resin) or a thermoplastic resin (such as an ethylene-vinyl acetate copolymer) or may be a mixture with these resin particles. The ratio of another resin relative to 100 parts by weight of the copolyamide-series resin may for example be about not more than 100 parts by weight (e.g., about 1 to 80 parts by weight), preferably about 2 to 70 parts by weight, more preferably about 2 to 50 parts by weight, and particularly not more than 30 parts by weight (e. g. , about 3 to 20 parts by weight).

If necessary, the copolyamide-series resin may contain various additives, for example, a filler, a stabilizer, a coloring agent, a plasticizer, a lubricant, a flame retardant, an antistatic agent, and a thermal conductive agent. The additives may be used alone or in combination. The ratio of the additive relative to 100 parts by weight of the copolyamide-series resin may be not more than 30 parts by weight, preferably about 0.01 to 20 parts by weight, and more preferably about 0.1 to 10 parts by weight.

Among the above-mentioned additives, for example, the stabilizer is widely used in light of prevention of weather degradation in a sealing film. The stabilizer may include, for example, a light stabilizer and a heat stabilizer (or an antioxidant).

As the light stabilizer, there may be mentioned a hindered amine-series light stabilizer (HALS), an ultraviolet ray absorbing agent, and others. The hindered amine-series light stabilizer usually has a tetramethylpiperidine ring skeleton (for example, 2,2,6,6-tetramethylpiperidine ring skeleton) and may include, for example, a low-molecular-weight HALS [for example, a tetramethylpiperidyl ester of a monocarboxylic acid (e.g., a C₂₋₆acyloxy-tetramethylpiperidine, a (meth)acryloyloxy-tetramethylpiperidine, and a C₆₋₁₀aroyloxy-tetramethylpiperidine), a tetramethylpiperidyl ester of a di- or poly-carboxylic acid (e.g., a tetramethylpiperidyl ester of a C₂₋₁₀aliphatic di- or poly-carboxylic acid, and a tetramethylpiperidyl ester of a C₆₋₁₀aromatic di- or poly-carboxylic acid), a tetramethylpiperidylamide of a di- or poly-carboxylic acid (e.g., a di(tetramethylpiperidylaminocarbonyl)C₁₋₄alkane and a di(tetramethylpiperidylaminocarbonyl)C₆₋₁₀arene), and a di(tetramethylpiperidyloxy)C₁₋₄alkane]; a high-molecular-weight HALS [for example, a polyester of a dicarboxylic acid (e.g., a C₂₋₆alkanedicarboxylic acid, and a C₆₋₁₀arenedicarboxylic acid) and a diol having a tetramethylpiperidine ring skeleton (e.g., N-hydroxyethyl-2,2,6,6-tetramethyl-4-hydroxypiperidine); and a straight- or branched-chain compound containing a triazine unit and an N,N'-bis(tetramethylpiperidyl)-C₂₋₆alkanediamine unit (e.g., "Tinuvin622LD", "Chimassorb 119", "Chimassorb 944", and "Chimassorb 2020", each manufactured by BASF)].

The ultraviolet ray absorbing agent may include, for example, a benzylidenemalonate-series ultraviolet ray absorbing agent [e.g., a tetraalkyl ester of phenylenebis(methylenemalonic acid) which may have a substituent (such as analkoxy group)], anoxanilide-series ultraviolet ray absorbing agent [e. g. , an oxanilide having a substituent (such as an alkyl group or an alkoxy group)], a benzotriazole-series ultraviolet ray absorbing agent [e. g. , a benzotriazole compound having a substituent (such as a hydroxy-alkyl-aryl group or a hydroxy-aralkyl-aryl group)], a benzophenone-series ultraviolet ray absorbing agent [e. g. , a hydroxybenzophenone compound which may have a substituent (such as an alkoxy group)], and a triazine-series ultraviolet ray absorbing agent [e.g., a diphenyltriazine compound having a substituent (such as a hydroxy-alkoxy-aryl group)].

The heat stabilizer (or antioxidant) is usually a phenolic heat stabilizer and may include, for example, a monocyclic hindered phenol compound [e.g., 2,6-di-t-butyl-p-cresol], a polycyclic hindered phenol compound having a chain or cyclic hydrocarbon group as a linking group [for example, a C₁₋₁₀alkylenebis- to tetrakis(t-butylphenol) compound, and a C₆₋₂₀arylenebis- to tetrakis(t-butylphenol) compound], a polycyclic hindered phenol compound having an ester-containing group as a linking group [for example, a bis- to tetrakis(t-butylphenol) compound having a linking group that is a C₂₋₁₀alkyl chain or (poly)C₂₋₄alkoxyC₂₋₄alkyl chain with two to four C₂₋₁₀alkylenecarbonyloxy groups as substituents, and a bis- to tetrakis(t-butylphenol) compound having a linking group that is a hetero ring (such as 2,4,8,10-tetraoxaspiro[5.5]undecane) with two to four C₂₋₁₀alkylenecarbonyloxy groups as substituents], and a polycyclic hindered phenol compound having an amide-containing group as a linking group [for example, abis-totetrakis(t-butylphenol) compound having a linking group that is a C₂₋₁₀alkyl chain with two to four C₂₋₁₀alkylenecarbonylamino groups as substituents]. The phenolic heat stabilizer may be used in combination with a phosphorus-containing heat stabilizer, a sulfur-containing heat stabilizer, or others.

These stabilizers may be used alone or in combination. Among these stabilizers, at least the light stabilizer (e.g., HALS) is used in practical cases. As the stabilizer, usually, the light stabilizer (e.g., combination of a HALS and an ultraviolet ray absorbing agent) is practically used in combination with the heat stabilizer (e.g. , a phenolic heat stabilizer). The ratio of the light stabilizer relative to 100 parts by weight of the copolyamide-series resin may be, for example, about 0.05 to 10 parts by weight, preferably about 0.1 to 7 parts by weight, and more preferably about 0.2 to 5 parts by weight; the ratio of the heat stabilizer relative to 100 parts by weight of the copolyamide-series resin may be, for example, about 0.01 to 5 parts by weight, preferably about 0.05 to 2 parts by weight, and more preferably about 0.1 to 1 part by weight.

The copolyamide-series resin is not limited to a specific form (or shape), and is a powdery or particulate form. For example, the copolyamide-series resin may be, for example, an amorphous form (such as pulverized matter), a spherical form, an ellipsoidal form, and others. The copolyamide-series resin particle may be composed of the copolyamide-series resin alone as described above or may be composed of a copolyamide-series resin composition containing the copolyamide-series resin and an additive. Moreover, the copolyamide-series resin particle may be, for example, a powdery mixture of copolyamide-series resin particles that differ in kind from each other or may be a particle of amoltenmixture of copolyamide-series resins that differ in kind from each other.

The particle size or average particle diameter (the value of the particle diameter at 50% in the cumulative distribution: D₅₀) of the copolyamide-series resin particle is not particularly limited to a specific one as far as the particle can uniformly be dispersed in the paste. The particle size or average particle diameter thereof may be not more than 500 µm, for example, about 0.1 to 400 µm (e.g., about 0.2 to 300 µm), preferably about 0.3 to 250 µm (e. g. , about 0.4 to 200 µm), and more preferably about 0.5 to 150 µm (e.g. , about 1 to 100 µm). The maximum diameter of the copolyamide-series resin particle may be not more than 1 mm, preferably not more than 500 µm (e.g., about 30 to 300 µm), and more preferably not more than 200 µm (e.g., about 50 to 150 µm). The average particle diameter and the maximum diameter can be measured by a measuring apparatus using a laser diffraction method (light-scattering method), for example, LA920 (manufactured by Horiba, Ltd.).

The copolyamide-series resin particle may be produced by pulverization using a conventional method (for example, freeze pulverization) and, if necessary, classification using a sieve or other means.

As the aqueous medium, there maybe mentioned water, a water-miscible organic solvent [for example, an alcohol (e.g., ethanol and ethylene glycol), a ketone (e.g., acetone), a cyclic ether (e.g., dioxane and tetrahydrofuran), acellosolve (e.g., methylcellosolve), a carbitol (e.g., methyl ethyl carbitol), and a glycol ether ester (e.g., cellosolve acetate)], and others. These aqueous media may be used alone or used as a mixed solvent. Among these aqueous media, water is widely used.

The boiling point of the aqueous medium is not particularly limited to a specific one. For example, if the aqueous medium has a boiling point not more than a sealing temperature (a heat-melting temperature of a paste sealant), the paste applied on a device or a substrate can be dried simultaneously with the melt-fusion (or deposition) of the copolyamide-series resin to the device or the substrate, and thus the sealing and molding cycles can be shortened. Specifically, the boiling point of the aqueous medium may be within the same range as the melting point or softening point of the copolyamide-series resin, for example, about 75 to 160°C and preferably about 80 to 150°C.

The ratio (amount) of the copolyamide-series resin relative to 100 parts by weight of the aqueous medium may be, for example, about 1 to 150 parts by weight, preferably about 5 to 120 parts by weight, and more preferably about 10 to 100 parts by weight (e.g., about 15 to 80 parts by weight, preferablyabout 20 to 50 parts by weight). A paste sealant containing the copolyamide-series resin at an excessively large ratio requires a longer time for melting, thereby causing bubble formation (air infiltration) and possible reduction of sealing performance to a device or a substrate.

If necessary, the paste sealant may contain a conventional additive, for example, a thickener, a viscosity modifier, a defoamer, a dispersing agent, a leveling agent,a coloring agent,afluorescent brightener, and a stabilizer. These additives may be used alone or in combination. Among these additives, at least a thickener is used in many cases. Generally, combination of a thickener with a dispersing agent and/or a defoamer is used in many cases.

The thickener is not particularly limited to a specific one as far as the thickener can control separation of the powdery copolyamide-series resin and the aqueous medium and can impart a viscidity to the paste sealant to allow uniform application (or coating) of the paste sealant on a substrate. The thickener may include a water-soluble polymer,for example,a cellulose derivative [e.g., an alkyl cellulose (e.g., a methyl cellulose), a hydroxyalkyl cellulose (e.g., a hydroxyethyl cellulose, a hydroxypropyl cellulose, and a hydroxypropylmethyl cellulose), and a carboxymethyl cellulose], a poly(ethylene glycol), a polyoxyethylene-polyoxypropylene copolymer, a poly (vinyl alcohol), a vinylpyrrolidone-series polymer (e.g., a poly(vinylpyrrolidone) and a vinylpyrrolidone-vinyl acetate copolymer), and a homopolymer or copolymer of a carboxyl group-containing monomer. These thickeners may be used alone or in combination. Among these thickeners, at least a homopolymer or copolymer of a carboxyl group-containing monomer is used in many cases.

The carboxyl group-containing monomer may include, for example, a polymerizable unsaturated monocarboxylic acid (such as acrylic acid or methacrylic acid); and a polymerizable unsaturated polycarboxylic (or polyvalent carboxylic) acid or an acid anhydride thereof (such as maleic acid (including maleic anhydride) or fumaric acid) . These carboxyl group-containing monomers may be used alone or in combination. A monomer polymerizable with the carboxyl group-containing monomer may include, for example, a (meth) acrylic monomer [e.g., a C₁₋₁₀alkyl (meth) acrylate such as methyl methacrylate, a hydroxyC₂₋₄alkyl (meth)acrylate, glycidyl (meth)acrylate, (meth)acrylamide, and an N-substituted (meth) acrylamide], a vinyl ester-series monomer (e.g., vinyl acetate), an aromatic vinyl-series monomer (e.g., styrene), a vinyl ether-series monomer (e.g., a C₁₋₆alkylvinyl ether), and vinylpyrrolidone. These polymerizable monomers may also be used alone or in combination. The ratio of the carboxyl group-containing monomer relative to the polymerizable monomer is not particularly limited to a specific one as far as the resulting homopolymer or copolymer has a function as a thickener; for example, the ratio [the former/the latter (weight ratio)] may be about 100/0 to 15/85, preferably about 100/0 to 20/80, and more preferably about 100/0 to 25/75 (e.g., about 99/1 to 30/70).

The homopolymer or copolymer of the carboxyl group-containing monomer preferably includes a homopolymer or copolymer of (meth) acrylic acid, for example, a poly (acrylic acid), a poly (methacrylic acid), an acrylic acid-methacrylic acid copolymer, a methyl methacrylate-acrylic acid copolymer, an acrylic acid-acrylamide copolymer, and an acrylic acid-(2-acrylamide-2-methylpropanesulfonic acid) copolymer. Among them, in terms of the easiness of handling (e.g. , viscosity control of the paste) and the contribution to an improved ability to seal a device or a substrate, a copolymer of (meth)acrylic acid and a polymerizable monomer including a (meth) acrylamide-series monomer (e.g., an acrylic acid-acrylamide copolymer) is preferred.

The homopolymer or copolymer of the carboxyl group-containing monomer may have an acid value of, for example, about 20 to 500 mgKOH/g, preferably about 50 to 300 mgKOH/g, and more preferably about 70 to 250 mgKOH/g.

The carboxyl group and a base may form a salt. The base may include an organic base [for example, an aliphatic amine (e.g. , a tertiary amine (e.g., a triC₁₋₄alkylamine such as triethylamine) and an alkanolamine (e.g., triethanolamine and N,N-dimethylaminoethanol)), and a heterocyclic amine (e.g., morpholine)], an inorganic base [for example, an alkali metal (e.g., sodium and potassium) and ammonia], and others.

The ratio of the thickener depends on the species of the copolyamide-series resin (for example, the concentration of a terminal amino group) and is, for example, about 0.1 to 35 parts by weight, preferably about 0.2 to 30 parts by weight, and more preferably about 0.5 to 25 parts by weight relative to 100 parts by weight of the copolyamide-series resin.

As the dispersing agent, for example, there may be mentioned a surfactant and a protective colloid. The ratio of the dispersing agent relative to 100 parts by weight of the copolyamide-series resin may for example be about not more than 30 parts by weight, preferably about 0.05 to 20 parts by weight, and more preferably about 0.1 to 10 parts by weight (e.g., about 0.5 to 5 parts by weight).

The defoamer may include a silicone-series defoamer, for example, a dimethylsilicone oil, an alkyl-modified silicone oil, and a fluorosilicone oil. These defoamers may be used alone or in combination. The ratio of the defoamer relative to 100 parts by weight of the copolyamide-series resin may be, for example, about not more than 10 parts by weight, preferably about 0.01 to 5 parts by weight, and more preferably about 0.05 to 1 part by weight.

The paste sealant may have a viscosity measured at a rotational frequency of 62.5 rpm by B-type viscometer at a temperature of 23°C of, for example, about 1 to 25 Pa·s, preferably about 1.2 to 22 Pa·s, and more preferably about 1.5 to 20 Pa·s (e.g., about 2 to 15 Pa·s). Moreover, the paste sealant may have a viscosity measured at a rotational frequency of 20 rpm by B-type viscometer at a temperature of 23°C of, for example, about 1.5 to 60 Pa·s, preferably about 2 to 55 Pa·s, and more preferably about 2.5 to 50 Pa·s (e.g., about 5 to 4 5 Pa·s). In a case where the above-mentioned viscosities are too small, the copolyamide-series resin particle and the aqueous medium are easy to separate, and there is a possibility that the paste spilled from a device or a substrate. Thus it is difficult to cover and seal a predetermined site (in particular, an uneven portion) uniformly and securely. In a case where above-mentioned viscosities are too large, bubble formation (air infiltration) occurs due to an increased melting time of the copolyamide-series resin. Thus it is difficult to seal a device or a substrate.

The paste sealant may have a thixotropic index [at a temperature of 23°C, the ratio (V1/V2) of the viscosity (V1) measured at a rotational frequency of 2 rpm by B-type viscometer relative to the viscosity (V2) measured at a rotational frequency of 20 rpm by B-type viscometer] of, for example, about 1.5 to 8, preferably about 1.7 to 7, and more preferably about 2 to 6. In a case where the thixotropic index is within the above-mentioned range, the paste sealant is easy to apply (or coat) due to a lower viscosity thereof, and in drying the paste sealant is prevented from spontaneous flow due to an increased viscosity thereof ; thus the paste sealant is advantageously used for forming a uniform coat.

Use of the copolyamide-series resin as a paste-form sealant allows (1) shortening of sealing and molding cycles even in a case where the sealant contains an aqueous medium. Moreover, (2) in an injection molding (in particular, a low-pressure injection molding) or a molding of a hot-melt resin, there is a limitation in the size of a device or substrate in connection with a mold, and only a device or substrate having a size of about 10 cm x 10 cm at the most can be sealed; in contrast, the paste sealant can seal a device without limitation in the size of the device. Further, (3) there is a possibility that a powdery sealant spills from a substrate or a device and cannot cover the substrate or the device, or a possibility that the powdery sealant cannot cover the substrate or the device uniformly due to the presence of mixed agglomerated and non-agglomerated portions of the powder body in the sealant; in contrast, the paste sealant can uniformly and securely cover or seal a predetermined site of a substrate or a device. Moreover, (4) although a film sealant cannot follow an uneven surface or a surface having depressed and raised portions (in particular, a surface having acutely or markedly depressed and raised portions), the paste sealant can easily follow the surface having depressed and raised portions to allow covering or sealing the surface. Thus, the paste sealant can efficiently mold an electronic device with high adhesion and high seal-ability, can protect the electronic device against water, moisture, contamination due to adhesion of dust, and others. In particular, the paste sealant containing acopolyamide-seriesresinimprovesadhesion to the device, imparts a high impact resistance and abrasion resistance to the device, and improves a protective effect relative to the device.

According to the method of the present invention, a device covered or molded with a copolyamide-series resin can be produced by a step for applying the paste sealant on at least part (a region) of a device, a step for heat-melting the paste sealant, and cooling the paste sealant.

The device may include various organic or inorganic devices, each requiring molding or sealing, for example, a precision part (e.g., a semiconductor element, an electroluminescent (EL) device, a light emitting diode, and a solar cell) or an electronic part (in particular, a precision electronic part or an electronic device) such as a circuit board (a printed wiring board) equipped or mounted with a part (such as various electronic parts or electronic devices).

In the applying step, the paste sealant may be applied on the whole of the device, or the device may optionally be masked and then the paste sealant may be applied on only a predetermined site. Further, a large amount of the paste sealant may be applied (or attached or spread) to apredeterminedportion (for example, arising portion or a corner portion) of the device.

The applied amount of the paste sealant (or the sol id matter in the paste sealant) maybe selected depending on the molding or covering amount, and may for example be about 0.1 to 100 mg/cm², preferably about 0.5 to 50 mg/cm², and more preferably 1 to 30 mg/cm².

The applying method is not particularly limited to a specific one and may include a conventional manner, for example, dipping, coating (for example, a roll coater, an air knife coater, a blade coater, a rod coater, a reverse coater, a bar coater, a comma coater, a dip and squeeze coater, a die coater, a gravure coater, a microgravure coater, and a silkscreen coater), and others.

In the heating step, the copolyamide-series resin adheres (or melt-adheres) to the device by heat-melting the paste sealant depending on the heat resistance of the device. The heating temperature may for example be about 75 to 200°C, preferably about 80 to 180°C, and more preferably about 100 to 175°C (e.g., about 110 to 150°C) depending on the melting point or softening point of the copolyamide-series resin. The heating can be carried out in air or in an inert gas atmosphere. The heating can be conducted in an oven, and if necessary, may use ultrasonic heating or high-frequency heating (electromagnetic heating). The heat-melting step may be carried out under an atmospheric pressure or an applied pressure. If necessary, the heat-melting step may be carried out under a reduced-pressure condition for defoaming. According to the present invention, since the paste applied to the device or the substrate can be dried in the process of the heating step, the sealing and molding efficiency is excellent.

Further, if necessary, the applying step and the heating step may be repeated. Moreover, after a copolyamide-series resin layer is formed on a first side (e.g., an upper surface) of the device as described above, the paste sealant may be applied and heat-melted on a second side (e.g., a bottom surface) of the device for molding and sealing both sides of the device including end faces thereof.

In the cooling step, the molten (or melt-adhered) copolyamide-series resin may be cooled spontaneously, or stepwise or continuously, or rapidly.

By these steps, a device at least a region of which is covered or molded with the copolyamide-series resin layer formed by the paste sealant can be obtained. The molding site of the device is usually a fragile or delicate site, for example, a site equipped with an electronic device and a wiring site.

According to the present invention, since drying of the paste and melt-adhesion (adhesion in the state of melting) of the copolyamide-series resin can be carried out simultaneously at a relatively low temperature, the reliability of the device can be improved due to a low thermal damage to the device. Moreover, differently from injection molding or the like, since a high pressure is not applied to the device, the device is not damaged due to a pressure. Thus, the sealant molds and seals the device with high reliability. In addition, the heating and cooling in a short period of time improves the production of the molded or sealed device greatly.

### EXAMPLES

The following examples are intended to describe this invention in further detail and should by no means be interpreted as defining the scope of the invention. The methods of the evaluation of evaluation items in the examples are as follows.

### [Melting time]

Each of paste samples obtained in Examples and Comparative Example was tested for the melting time, as follows. A glass plate having a size of 26 mm x 76 mm was placed on an iron plate (thickness: 1 mm). The paste sample (2 g) was spread on the center of the glass plate. The resulting test specimen was placed in an oven at 170°C (Examples) or 250°C (Comparative Example), and the time required to melt the solid matter in the paste and give a flat surface of the sample was measured.

### [Sealing performance]

The sealing performance of a sealant was evaluated for both of a flat surface of a substrate and a protruded portion having a side face (height: 2 mm or 20 mm) rising perpendicularly from a flat surface of a substrate on the basis of the following criteria.
5: The flat surface or the protruded portion is wholly covered with the sealant.
4: The flat surface or the protruded portion is almost wholly covered, but entering of air is partly observed between the substrate and the sealant.
3: Half of the sealant peels off from the flat surface or the protruded portion.
2: The sealant partly adheres to the flat surface or the protruded portion, but the sealant mostly peels off from the flat surface or the protruded portion.
1: The sealant wholly peels off from the flat surface or the protruded portion.

### [Peel test]

A test piece comprising a glass epoxy substrate sealed with a sealant of Examples and Comparative Example was evaluated for the adhesion between the substrate and the film according to a cross-cut test.

### [Water resistance test]

Each of sealants obtained in Examples and Comparative Example was tested for LED lighting test, as follows. A LED-mounting glass epoxy substrate sealed with the sealant was immersed in water at 23°C for 100 hours. Thereafter, if the LED was on, the sealant was graded "A"; if the LED was off, the sealant was graded "B".

### [Raw material]

Copolyamide 1: VESTAMELT X1051, manufactured by Evonik, containing a C₁₀₋₁₄alkylene group, melting point: 130°C (DSC), melt flow rate: 15 g/10 minutes (a temperature of 160°C and a load of 2.16 kg)
Copolyamide 2 : VESTAMELT X1038, manufactured by Evonik, containing a C₁₀₋₁₄alkylene group, melting point: 125°C (DSC), melt flow rate: 15 g/10 minutes (a temperature of 160°C and a load of 2.16 kg)
Copolyamide 3: VESTAMELT N1901, manufactured by Evonik, containing a C₁₀₋₁₄alkylene group, melting point: 155°C (DSC), melt flow rate: 5 g/10 minutes (a temperature of 190°C and a load of 2.16 kg)
Homopolyamide: DAIAMID A1709, manufactured by Daicel-Evonik Ltd., polyamide 12, melting point: 178°C (DSC), melt flow rate: 70 g/10 minutes (a temperature of 190°C and a load of 2.16 kg)
Thickener 1: manufactured by BOZZETTO GmbH, MIROX VD65, containing an acrylamide-ammonium acrylate copolymer
Thickener 2: manufactured by Nihon Junyaku Co., Ltd., RHEOGIC 252L, sodium polyacrylate
Dispersing agent: manufactured by BOZZETTO GmbH, MIROX MD, containing a C₆₋₁₂alkylethyl ether
Defoamer: manufactured by BOZZETTO GmbH, MIROX AS1, a silicone-series defoamer

### Examples 1 to 12

A copolyamide (VESTAMELT X1051, VESTAMELT X1038, VESTAMELT N1901) was freeze-pulverized and passed through a wire mesh (or wire gauze) (opening size: 80 µm) to give powdery resin particle samples, each having an average particle diameter of 49 µm and a particle size of 0.5 to 80 µm. The resulting resin particle samples were used to prepare pastes in accordance with the formulation shown in the following Table 1. Each of the pastes was uniformly spread on an electronic substrate made of a glass epoxy resin (200 mm x 200 mm), and then heated in an atmosphere of a temperature of 170°C to give a substrate coated with the transparent resin.

### Comparative Example 1

A homopolyamide (DAIAMID A1709) was freeze-pulverized and passed through a wire mesh (opening size : 80 µm) to give a powdery resin particle sample having an average particle diameter of 53 µm and a particle size of 0.5 to 80 µm. The resulting resin particle sample was used to prepare a paste in accordance with the formulation shown in the following Table 1. The paste was uniformly spread on an electronic substrate made of a glass epoxy resin (200 mm x 200 mm), and then heated in an atmosphere of a temperature of 250°C to give a substrate coated with the resin. The adhesion of the resin to the substrate was not observed at all.

Each sealant obtained in Examples and Comparative Example was evaluated for sealing performance, peeling property, and water resistance. The results are shown in Table 1. In the table, each numerical value in the peel test and the water resistance test indicates the number of peeled squares out of 100 squares in the cross-cut peel test.

[Table 1]

**Table 1**

| | | Examples | | | | | Comparative Example |
|---|---|---|---|---|---|---|---|
| | | 1 | 2 | 3 | 4 | 5 | 1 |
| Water | | 700 g | 700 g | 900 g | 600 g | 550 g | 700 g |
| Dispersing agent | | 3.5 g | 3.5 g | 3.5 g | 3.5 g | 3.5 g | 3.5 g |
| Defoamer | | 1 g | 1 g | 1 g | 1 g | 1 g | 1 g |
| Copolyamide (Copolyamide 1) | | 300 g | 300 g | 100 g | 400 g | 450 g | - |
| Homopolyamide | | - | - | - | - | - | 300 g |
| Thickener (Thickener 1) | | 7 g | 26 g | 24 g | 7 g | 4 g | 7 g |
| Solid content | | 30% | 30% | 10% | 40% | 45% | 30% |
| Viscosity (mPa·s) measured at 23°C using VT04E manufactured by RION | 62.5rpm | 1700 | 20000 | 9000 | 8500 | 4000 | 1800 |
| | Rotor | 1 | 2 | 1 | 1 | 1 | 1 |
| Viscosity (mPa·s) measured at 23°C using a B-type viscometer (BH type) manufactured by TOKI SANGYO CO. LTD | 2 rpm | 8500 | 261500 | 105000 | 57000 | 10800 | 9000 |
| | 4 rpm | 5950 | 156250 | 61000 | 37500 | 8600 | 6200 |
| | 10 rpm | 3730 | 79400 | 30200 | 21800 | 6720 | 4050 |
| | 20 rpm | 2630 | 47500 | 17980 | 14320 | 5570 | 2990 |
| | Rotor | 3 | 6 | 5 | 5 | 4 | 1 |
| Melting time (sec.) | | 90 | 180 | 78 | 113 | 173 | 128 |
| Flat | | 5 | 4 | 5 | 5 | 5 | 1 |
| Protruded portion 2 mm | | 5 | 4 | 5 | 5 | 4 | 1 |
| Protruded portion 20 mm | | 5 | 4 | 5 | 5 | 4 | 1 |
| Peel test | | 0 | 0 | 0 | 0 | 0 | 100 |
| Water resistance test (LED lighting test) | | A | A | A | A | A | - |

**Table 2**

| | | Examples | | | | | | |
|---|---|---|---|---|---|---|---|---|
| | | 6 | 7 | 8 | 9 | 10 | 11 | 12 |
| Water | | 600 g | 900 g | 600 g | 600 g | 900 g | 600 g | 600 g |
| Dispersing agent | | 3.5 g | 3.5 g | 3.5 g | 3.5 g | 3.5 g | 3.5 g | 3.5 g |
| Defoamer | | 1 g | 1 g | 1 g | 1 g | 1 g | 1 g | 1 g |
| Copolyamide 1 | | 400 g | - | - | - | - | - | - |
| Copolyamide 2 | | - | 100 g | 400 g | 400 g | - | - | - |
| Copolyamide 3 | | - | - | - | - | 100 g | 400 g | 400 g |
| Thickener 1 | | - | 24 g | 7 g | - | 24 g | 7 g | - |
| Thickener 2 | | 7 g | - | - | 7 g | - | - | 7 g |
| Solid content | | 40% | 10% | 40% | 40% | 10 % | 40% | 40% |
| Viscosity (mPa·s) measured at 23°C using VT04E manufactured by RION | 62.5 rpm | 7000 | 9500 | 10000 | 8400 | 8500 | 8200 | 7500 |
| | Rotor | 1 | 1 | 1 | 1 | 1 | 1 | 1 |
| Viscosity (mPa·s) measured at 23°C using a B-type viscometer (BH type) manufactured by TOKI SANGYO CO. LTD | 2 rpm | 35000 | 120000 | 62000 | 55000 | 98000 | 97000 | 85000 |
| | 4 rpm | 21500 | 78000 | 43500 | 34500 | 54500 | 53500 | 43000 |
| | 10 rpm | 14800 | 42500 | 25800 | 20800 | 27200 | 26800 | 23000 |
| | 20 rpm | 8760 | 19900 | 18300 | 13500 | 15980 | 14300 | 12300 |
| | Rotor | 5 | 5 | 5 | 5 | 5 | 5 | 5 |
| Melting time (sec.) | | 93 | 67 | 85 | 92 | 121 | 118 | 107 |
| Flat | | 4 | 5 | 5 | 5 | 5 | 5 | 5 |
| Protruded portion 2 mm | | 4 | 5 | 4 | 4 | 4 | 5 | 4 |
| Protruded portion 20 mm | | 4 | 5 | 4 | 4 | 4 | 5 | 4 |
| Peel test | | 0 | 0 | 0 | 0 | 0 | 0 | 0 |
| Water resistance test (LED lighting test) | | A | A | A | A | A | A | A |

As apparent from Table 1, compared with Comparative Example, Examples show high sealing performance in both the flat portion and the protruded portion as well as have excellent adhesion and water resistance. Moreover, the sealants of Examples allow quick melting at a low temperature and shortening of sealing and molding cycles.

### INDUSTRIAL APPLICABILITY

The present invention is useful for molding or sealing of an electronic device or electronic part (e.g. , a semiconductor element, an EL device, and a solar cell) or a printed wiring board equipped with a variety of electronic parts or electronic devices at a low temperature.

## Claims

1. A paste sealant for molding and sealing a device, the sealant comprising a copolyamide-series resin and an aqueous medium.

2. A paste sealant according to claim 1, which further comprises a thickener.

3. A paste sealant according to claim 2, wherein the thickener comprises a (meth)acrylic acid-series polymer.

4. A paste sealant according to any one of claims 1 to 3, which has a viscosity of 1.5 to 25 Pa·s measured at a rotational speed of 62.5 rpm by B-type viscometer at a temperature of 23°C.

5. A paste sealant according to any one of claims 1 to 4, wherein, at a temperature of 23°C, the ratio of the viscosity measured at a rotational speed of 2 rpm by B-type viscometer relative to the viscosity measured at a rotational speed of 20 rpm by B-type viscometer is 1.5 to 8 in a ratio of the former/the latter.

6. A paste sealant according to any one of claims 1 to 5, wherein the ratio of the copolyamide-series resin relative to 100 parts by weight of the aqueous medium is 10 to 100 parts by weight.

7. A paste sealant according to any one of claims 1 to 6, wherein the copolyamide-series resin has a melting point or softening point of 75 to 160°C.

8. A paste sealant according to any one of claims 1 to 7, wherein the copolyamide-series resin is a crystalline resin.

9. A paste sealant according to any one of claims 1 to 8, wherein the copolyamide-series resin is a crystalline resin and has a melting point of 90 to 160°C.

10. A paste sealant according to any one of claims 1 to 9, wherein the copolyamide-series resin comprises a multiple copolymer.

11. A paste sealant according to any one of claims 1 to 10, wherein the copolyamide-series resin comprises at least one selected from the group consisting of a binary copolymer to a quaternary copolymer.

12. A paste sealant according to any one of claims 1 to 11, wherein the copolyamide-series resin contains a unit derived from a long-chain component having a C₈₋₁₆alkylene group.

13. A paste sealant according to any one of claims 1 to 12, wherein the copolyamide-series resin contains a unit derived from at least one component selected from the group consisting of a C₉₋₁₇ lactam and an aminoC₉₋₁₇alkanecarboxylic acid.

14. A paste sealant according to any one of claims 1 to 13, wherein the copolyamide-series resin contains a unit derived from an amide-forming component selected from the group consisting of a polyamide 11, a polyamide 12, a polyamide 610, a polyamide 612, and a polyamide 1010.

15. A paste sealant according to any one of claims 1 to 14, wherein the copolyamide-series resin comprises at least one member selected from the group consisting of a copolyamide 6/11, a copolyamide 6/12, a copolyamide 66/11, a copolyamide 66/12, a copolyamide 610/11, a copolyamide 612/11, a copolyamide 610/12, a copolyamide 612/12, a copolyamide 1010/12, a copolyamide 6/11/610, a copolyamide 6/11/612, a copolyamide 6/12/610, and a copolyamide 6/12/612.

16. A paste sealant according to any one of claims 1 to 15, wherein the copolyamide-series resin contains a unit derived from at least one component selected from the group consisting of laurolactam, aminoundecanoic acid, and aminododecanoic acid.

17. A process for producing a device covered or molded with a copolyamide-series resin, the process comprising:
applying a paste sealant recited in any one of claims 1 to 16 to at least a region of a device, heat-melting the paste sealant, and
cooling the paste sealant.

18. A device of which at least a region is covered or molded with a copolyamide-series resin layer, the layer comprising a paste sealant recited in any one of claims 1 to 17.
